# EUROPÄISCHE PATENTANMELDUNG

(11) **EP 1 389 802 A1**
(43) Veröffentlichungstag der Anmeldung: **18.02.2004**
(21) Anmeldenummer: 02405701.0
(22) Anmeldetag: 16.08.2002
(51) Int. Cl.: H01L 23/48, H01L 23/051, H01L 25/07

(54) **Schutzschicht für Leistungshalbleitermodul-Kontaktplättchen**

(71) Anmelder: ABB Schweiz AG, 5400 Baden (CH)
(72) Erfinder: Assal, Jérome, 8004 Zürich (CH); Kaufmann, Stefan, 5000 Aarau (CH)
(74) Vertreter: ABB Patent Attorneys

(57) **Zusammenfassung**

Die Erfindung betrifft ein Leistungshalbleitermodul mit mindestens einem Halbleiterchip (11) aus einem Halbleitermaterial und mit einer ersten und einer zweiten Hauptelektrode (12, 13), einem ersten und einem zweiten Hauptanschluss (91, 92) und einem Kontaktplättchen (2) in elektrischem Kontakt mit der ersten Hauptelektrode (12) und dem ersten Hauptanschluss (92). Das Kontaktplättchen (2) enthält einen Legierungspartner, welcher mit dem Halbleitermaterial ein Eutektikum bilden kann. Erfindungsgemäss ist das Kontaktplättchen mit einer elektrisch leitenden Schutzschicht (31, 32) überzogen, durch welche eine Ausbildung einer festen Materialverbindung zwischen der ersten Hauptelektrode (12) und dem Kontaktplättchen (2) verhindert wird.

## Beschreibung

### Technisches Gebiet

Die vorliegende Erfindung bezieht sich auf das Gebiet der Leistungselektronik. Sie betrifft ein Leistungshalbleitermodul nach dem Oberbegriff des ersten Anspruchs, insbesondere ein IGBT-(Insulated Gate Bipolar Transistor) oder Dioden-Modul.

### Stand der Technik

Bei Leistungshalbleitermodulen, insbesondere bei Leistungshalbleitermodulen, welche mindestens einen ersten Halbleiterchip umfassen, der intern eine IGBT- oder Diodenstruktur aufweist, soll häufig eine Kurzschlussfestigkeit gewährleistet sein. Unter Kurzschlussfestigkeit versteht man dabei die Tatsache, dass sich im Falle eines Defekts eines ersten Halbleiterchips zwischen einem ersten Hauptanschluss des Leistungshalbleitermoduls, welcher mit einer ersten Hauptelektrode des ersten Halbleiterchips elektrisch verbunden ist, und einem zweiten Hauptanschluss des Halbleitermoduls, welcher mit einer zweiten Hauptelektrode des ersten Halbleiterchips elektrisch verbunden ist, ein stabiler Kurzschluss ausbildet. In einem daraus resultierenden Kurzschlussmodus soll zwischen den beiden Hauptanschlüssen ein dauerhafter elektrischer Kontakt mit möglichst geringem Widerstand und möglichst grosser Stromkapazität bestehen. Deswegen spricht die englische Fachterminologie auch von einem "short circuit failure mode", kurz SCFM. In der unter EP 989611 A2 veröffentlichten europäischen Patentanmeldung wird beschrieben, wie mit Hilfe eines geeigneten Kontaktelements, welches in Kontakt mit der ersten Hauptelektrode eines jeden Halbleiterchips steht, eine derartige Kurzschlussfestigkeit erreicht wird. Das Kontaktelement wird von einer elektrisch leitenden Schicht, beispielsweise einem Plättchen, einer Scheibe oder einer Folie, gebildet und muss einen Legierungspartner enthalten, der mit einem Halbleitermaterial des Halbleiterchips ein Eutektikum bilden kann, d.h. eine Verbindung oder Legierung, deren Schmelzpunkt niedriger liegt als der Schmelzpunkt des reinen Halbleitermaterials und zugleich niedriger als der Schmelzpunkt des reinen Legierungspartners. Bei einem Defekt des ersten Halbleiterchips schmilzt dieser unter Eutektikumsbildung mit dem Legierungspartner auf und es bildet sich ein metallisch leitender Kanal zwischen der ersten und zweiten Hauptelektrode.

Für Halbleiterchips aus Si eignen sich insbesondere Al, Ag, Au, Cu oder Mg oder auch eine Verbindung dieser Elemente als Legierungspartner. Bei druckkontaktierten Leistungshalbleitermodulen kann vorteilhaft eine Folie oder ein Plättchen als Kontaktelement auf die erste Hauptelektrode eines jeden Halbleiterchips gelegt und durch Druck, der beispielsweise über Kontaktstempel übertragen wird, fixiert werden.

Bei einer derartigen Konfiguration können sich jedoch Probleme dadurch ergeben, dass sich im Laufe der Zeit eine feste Materialverbindung zwischen erster Hauptelektrode und Folie oder Plättchen ausbildet, die nur noch unter grossem Kraftaufwand lösbar ist, was im Allgemeinen eine Zerstörung der ersten Hauptelektrode und damit des Halbleiterchips mit sich bringt. Dies wird dadurch verursacht, dass die Folie oder das Plättchen mit der ersten Hauptelektrode aufgrund des ausgeübten Drucks und von Temperaturschwankungen und -zyklen bei einem Betrieb des Leistungshalbleitermoduls gewissermassen kaltverschweisst wird. Aufgrund unterschiedlicher thermischer Ausdehnungskoeffizienten zwischen dem Kontaktelement und dem Halbleiterchip ergibt sich beim Betrieb des Leistungshalbleitermoduls eine starke mechanische Belastung der ersten Hauptelektrode, die dazu führen kann, dass sich eine Elektrodenmetallisierung im Laufe der Zeit ablöst, wodurch der Halbleiterchip zerstört wird. Diese Erscheinung kann in ungünstigen Fällen sogar nur durch Reibung zwischen den Oberflächen des Kontaktelements und der ersten Hauptelektrode, d.h. ohne dass sich eine feste Materialverbindung ausgebildet hat.

Ein weiteres Problem ergibt sich bei nicht luftdicht abgeschlossenen Leistungshalbleitermodulen in Verbindung mit einem Kontaktelement, welches im wesentlichen aus Al besteht. Es ist allgemein bekannt, dass Al innerhalb von Sekunden eine einige Nanometer dicke Oxidschicht bildet, sobald es bei Raumtemperatur mit Luft in Berührung kommt. Da diese Schicht isolierend und zudem im Allgemeinen härter als die Elektrodenmetallisierung der ersten Hauptelektrode ist, wird durch sie ein Kontaktwiderstand zwischen dem Kontaktelement und der ersten Hauptelektrode erhöht, im schlimmsten Fall so stark, dass beim Betrieb des Leistungshalbleitermoduls eine durch den Kontaktwiderstand erzeugte Wärme das Leistungshalbleitermodul zerstört.

### Darstellung der Erfindung

Es ist somit Aufgabe der Erfindung, ein kurzschlussfestes Leistungshalbleitermodul mit mindestens einem Halbleiterchip anzugeben, welches ein Kontaktelement, aufweist bei welchem die im letzten Abschnitt genannten Probleme nicht auftreten.

Diese und weitere Aufgaben werden durch ein Leistungshalbleitermodul der eingangs genannten Art mit den Merkmalen des unabhängigen Patentanspruchs gelöst. Weitere vorteilhafte Ausgestaltungen der Erfindung sind in den abhängigen Ansprüchen angegeben.

Das erfindungsgemässe Leistungshalbleitermodul weist als Kontaktelement ein elektrisch leitendes Kontaktplättchen auf, welches mit einer ersten Hauptelektrode des Halbleiterchips und einem ersten Hauptanschluss des Leistungshalbleitermoduls elektrisch leitend verbunden ist, und welches mit einer elektrisch leitenden Schutzschicht überzogen ist. Dabei ist die Schutzschicht vorzugsweise so beschaffen, dass sie an einer äusseren Kontaktfläche ein Material aufweist, welches
- möglichst nicht oxidierbar ist, vorzugsweise chemisch wenig reaktionsfreudig ist, oder
- mit einer ersten Elektrodenmetallisierung der ersten Hauptelektrode chemisch nicht reagiert und möglichst weder Kontaktkorrosion noch Materialdiffusion zeigt, oder
- einen möglichst geringen Reibungskoeffizienten aufweist, oder
- bei Temperaturen abgeschieden werden kann, bei welchen die Kontaktschicht nicht beschädigt oder verformt wird,
oder welches eine beliebige Kombination von zwei oder mehr der genannten Eigenschaften besitzt.

In einer bevorzugten Weiterbildung des erfindungsgemässen Leistungshalbleitermoduls weist die Schutzschicht eine geschichtete Struktur auf und, umfasst zumindest eine Oberflächenschicht, welche die äussere Kontaktfläche bildet, und eine Basisschicht. Dabei ist die Oberflächenschicht aus einem Material gebildet, welches eine der im letzten Ansatz genannten Eigenschaften oder eine beliebige Kombination von zwei oder mehr dieser Eigenschaften besitzt.

Diese und weitere Aufgaben, Vorteile und Merkmale der Erfindung werden aus der nachfolgenden, detaillierten Beschreibung eines bevorzugten Ausführungsbeispiels der Erfindung in Verbindung mit der Zeichnung offensichtlich.

### Kurze Beschreibung der Zeichnung

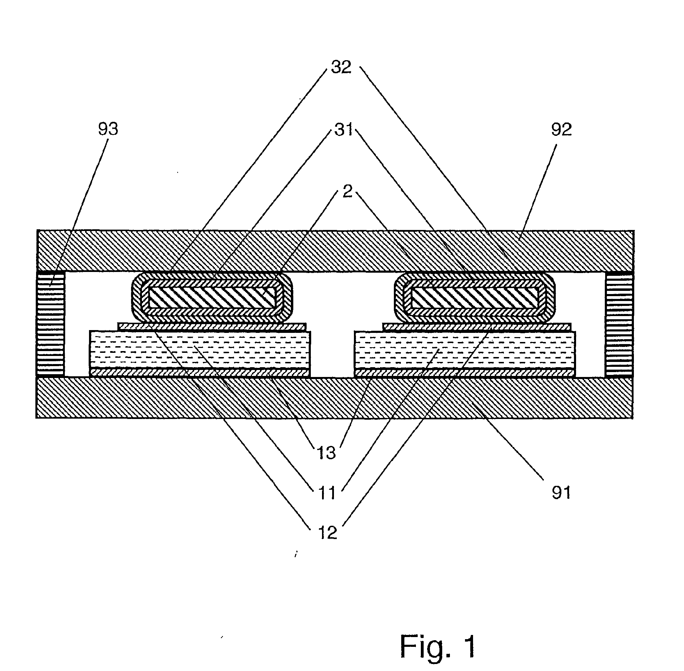

Fig. 1 zeigt schematisch einen Querschnitt durch ein erfindungsgemässes Leistungshalbleitermodul

Die in der Zeichnung verwendeten Bezugszeichen und deren Bedeutung sind in der Bezugszeichenliste zusammengefasst. Grundsätzlich bezeichnen gleiche Bezugszeichen gleiche Teile.

### Wege zur Ausführung der Erfindung

Fig. 1 zeigt schematisch einen Querschnitt durch ein erfindungsgemässes Leistungshalbleitermodul.

Ein Halbleiterchip 11 mit einer ersten und einer zweiten Hauptelektrode befindet sich zwischen einer elektrisch leitenden Bodenplatte 91, die einen zweiten Hauptanschluss des Leistungshalbleitermoduls bildet, und einer elektrisch leitenden Deckplatte 92, die einen;ersten Hauptanschluss des Leistungshalbleitermoduls bildet. Erste bzw. zweite Hauptelektrode weisen eine erste bzw. zweite Elektrodenmetallisierung 11 bzw. 12 auf. Zwischen erster Hauptelektrode und Deckplatte 92 befindet sich ein Kontaktplättchen 2, das mit einer Schutzschicht bezogen ist, die aus einer Basisschicht 31 und einer Oberflächenschicht 32 besteht. Das Modul wird von Seitenwänden 93 abgeschlossen, wobei dieser Abschluss nicht notwendigerweise hermetisch sein muss. Eine erste Dicke des Kontaktplättchens 2 beträgt dabei vorzugsweise mindestens die Hälfte einer zweiten Dicke des Halbleiterchips 11. Dabei kann das Kontaktplättchen 2 vorteilhaft durch Ausschneiden oder Ausstanzen aus einer Folie gewonnen werden. Vorzugsweise wird jedoch ein noch dickeres Kontaktplättchen 2 mit einer ersten Dicke im Bereich einiger zehntel Millimeter bis einiger Millimeter verwendet, vorzugsweise mit einer ersten Dicke von angenähert einem Millimeter. In diesem Fall kann das Kontaktplättchen 2 vorteilhaft durch Ausschneiden oder Ausstanzen aus einem Blech gefertigt werden.

Das Kontaktplättchen 2 besteht vorzugsweise im wesentlichen aus Al oder Ag. Diese Materialien sind einerseits relativ kostengünstig. Es hat sich ausserdem herausgestellt, das die Eutektikumsbildung im Falle von Si als Halbleitermaterial bei Kontaktplättchen 2 aus Ag und Al besonders zuverlässig erfolgt und durch den gesamten Halbleiterchip 11 hindurchgreift. Dies ist unter anderem darauf zurückzuführen, dass Ag und Al mit Si keine Zwischenphasen ausbilden. Unter Zwischenphasen versteht man Mischungen mit einem Mengenverhältnis innerhalb einer gewissen Bandbreite oder auch einem streng stöchiometrischen Mengenverhältnis, die durch bestimmte physikalische Eigenschaften charakterisiert sind. Solche Zwischenphasen sind relativ stabil und behindern einen Diffusionsprozess, so dass eine Durchlegierung des Halbleiterchips 11 nicht mehr garantiert ist. Das Kontaktplättchen 2 kann jedoch vorteilhaft auch im wesentlichen aus Cu, Au oder Mg oder aus einer Legierung aus zweien oder mehreren der Metalle Al, Ag, Au, Cu oder Mg bestehen.

Die Oberflächenschicht 32 besteht vorzugsweise im wesentlichen aus einem Edelmetall, vorteilhaft aus Ag, Au, Pd, Rh oder Ru. Vorzugsweise weist die Oberflächenschicht 32 eine dritte Dicke von 0.1µm bis 5 µm, vorzugsweise von angenähert 0.2 µm auf. Vorzugsweise kann die Oberflächenschicht 32 auch im wesentlichen aus einem elektrisch leitenden Nitrid, vorteilhaft aus TiN, CrN oder ZrN, oder aus Graphit bestehen. In diesem Fall beträgt die dritte Dicke vorzugsweise 0.1µm bis 5µm, vorzugsweise angenähert 1µm. Unter "A besteht im wesentlichen aus X" ist hier und im folgenden zu verstehen, dass X diejenige Substanz mit dem gewichtsmässig grössten Anteil aller Substanzen X, Y, Z, ..., ist, welche der Gegenstand A enthält. Vorzugsweise hat X dabei einen Gewichtsanteil von mindestens 90%. A kann aber vorteilhaft auch aus reinem X bestehen.

In einer bevorzugten Ausgestaltung der Erfindung besteht das Kontaktplättchen 2 im wesentlichen aus Al oder Mg, und die Schutzschicht weist eine Basisschicht 31 aus einem guten Deckmaterial, vorzugsweise chemisch oder galvanisch abgeschiedenem Ni, auf. Eine vierte Dicke der Basisschicht 31 beträgt dabei vorzugsweise einige Mikrometer, vorzugsweise angenähert zwischen 1 und 15 Mikrometer, vorzugsweise angenähert zwischen 2 und 3 Mikrometer. Durch die Basisschicht 31 wird dabei eine Kontaktkorrosion zwischen dem Kontaktplättchen 2 und der Oberflächenschicht 32 verhindert.

In einer bevorzugten Ausgestaltung der Erfindung besteht die Oberflächenschicht 32 im wesentlichen aus Rh, Ru oder aus einem elektrisch leitenden Nitrid, vorzugsweise aus TiN, CrN oder ZrN. Rh weist bei üblichen Betriebstemperaturen nur eine sehr schwache, Ru und Nitrid sogar überhaupt keine Diffusion an Kontakten mit einer ersten Elektrodenmetallisierung 11 aus Ag auf. Die Ausbildung einer festen Materialverbindung zwischen erster Elektrodenmetallisierung 11 und Kontaktplättchen 2 wird somit besonders wirkungsvoll verhindert. Besteht das Kontaktplättchen 2 im wesentlichen aus Al oder Mg und die Oberflächenschicht 32 im wesentlichen aus Ru, ist die Basisschicht 31 vorteilhaft etwas dicker, vorzugsweise angenähert zwischen 6µm und 15µm. Dies ist insbesondere dann wichtig, wenn Ru in einem Ru-Bad abgeschieden wird, in welchem typischerweise ein pH-Wert von angenähert 1 herrscht, und welches deswegen chemisch sehr aggressiv ist. Vorteilhaft ist zudem eine dünne Goldschicht zwischen der Basisschicht 31 aus Ni und der Oberflächenschicht 32 vorgesehen, um eine Adhäsion zwischen Ni und Ru zu verbessern.

Eine fünfte Dicke der Goldschicht liegt dabei vorzugsweise im Bereich einiger Zehntel Mikrometer, vorzugsweise beträgt sie angenähert 0.2 Mikrometer.

In einer bevorzugten Ausgestaltung der Erfindung besteht die Schutzschicht nur aus einer einzelnen Schicht, vorzugsweise aus einem Edelmetall, vorteilhaft im wesentlichen aus Ag, Au, Pd, Rh oder Ru. Eine sechste Dicke der Schutzschicht beträgt dabei vorzugsweise zwischen 0.1µm und 5µm, vorzugsweise angenähert 0.2µm. Vorzugsweise kann die Oberflächenschicht 32 auch im wesentlichen aus einem elektrisch leitenden Nitrid, vorteilhaft aus TiN, CrN oder ZrN, oder aus Graphit bestehen. Die sechste Dicke der Schutzschicht beträgt in diesem Fall vorzugsweise zwischen 0.1µm und 5µm, vorzugsweise angenähert 1µm.

### Bezugszeichenliste

- 11: Halbleiterchip
- 12: Erste Elektrodenmetallisierung der ersten Hauptelektrode
- 13: Zweite Elektrodenmetallisierung der zweiten Hauptelektrode
- 2: Kontaktplättchen
- 31: Basisschicht
- 32: Oberflächenschicht
- 91: Bodenplatte
- 92: Deckplatte
- 93: Seitenwand

## Patentansprüche

1. Leistungshalbleitermodul, umfassend
- mindestens einen Halbleiterchip (11) aus einem Halbleitermaterial und mit einer ersten und einer zweiten Hauptelektrode,
- einen ersten und zweiten Hauptanschluss (91, 92),
- ein Kontaktplättchen (2) in elektrischem Kontakt mit der ersten Hauptelektrode und dem ersten Hauptanschluss (92),
- wobei das Kontaktplättchen (2) einen Legierungspartner enthält und zwischen dem Legierungspartner und dem Halbleitermaterial ein Eutektikum bildbar ist,
**dadurch gekennzeichnet, dass**
- das Kontaktplättchen mit einer elektrisch leitenden Schutzschicht (31, 32) überzogen ist.

2. Leistungshalbleitermodul nach Anspruch 1, **dadurch gekennzeichnet, dass**
- das Kontaktplättchen (2) im wesentlichen aus Ag oder Al besteht.

3. Leistungshalbleitermodul nach einem der Ansprüche 1 oder 2, **dadurch gekennzeichnet, dass**
- eine äussere Kontaktfläche der Schutzschicht (31, 32) im wesentlichen aus einem Edelmetall, vorzugsweise Ag, Au, Pd, Rh oder Ru besteht.

4. Leistungshalbleitermodul nach einem der Ansprüche 1 oder 2, **dadurch gekennzeichnet, dass**
- eine äussere Kontaktfläche der Schutzschicht (31, 32) im wesentlichen aus einem elektrisch leitenden Nitrid, vorzugsweise aus TiN, CrN oder ZrN, besteht.

5. Leistungshalbleitermodul nach einem der Ansprüche 1 oder 2, **dadurch gekennzeichnet, dass**
- eine äussere Kontaktfläche der Schutzschicht (31, 32) im wesentlichen aus einem Graphit besteht.

6. Leistungshalbleitermodul nach einem der Ansprüche 3 bis 5, **dadurch gekennzeichnet, dass**
- das Kontaktplättchen (2) im wesentlichen aus Al oder Mg besteht,
- die Schutzschicht (31, 32) mindestens eine elektrisch leitende Basisschicht (31), welche auf dem Kontaktplättchen (2) aufgebracht ist, und
- eine elektrisch leitende Oberflächenschicht (32), welche die äussere Kontaktfläche bildet, aufweist.

7. Leistungshalbleitermodul nach Anspruch 6, **dadurch gekennzeichnet, dass**
- die Basisschicht (31) im wesentlichen aus Ni besteht und vorzugsweise eine vierte Dicke zwischen angenähert 1µm und 15µm, vorzugsweise zwischen 2µm und 8µm, aufweist.

8. Leistungshalbleitermodul nach Anspruch 6 oder 7, **dadurch gekennzeichnet, dass**
- die Oberflächenschicht (32) eine dritte Dicke zwischen angenähert 0.1µm und 5µm aufweist.

9. Leistungshalbleitermodul nach einem der Ansprüche 6 bis 8, **dadurch gekennzeichnet, dass**
- die Oberflächenschicht (32) im wesentlichen aus Ru besteht,
- zwischen der Oberflächenschicht (32) und der Basisschicht (31) eine elektrisch leitende Zwischenschicht vorgesehen ist, welche im wesentlichen aus Au besteht und vorzugsweise eine fünfte Dicke von angenähert 0.2µm aufweist und
- die Basisschicht (31) vorzugsweise eine vierte Dicke zwischen 5µm und 12µm aufweist.

10. Leistungshalbleitermodul nach einem der vorangehenden Ansprüche, **dadurch gekennzeichnet, dass**
- der Halbleiterchip (11) intern eine IGBT-Struktur oder eine Diodenstruktur aufweist.
